# EUROPEAN PATENT APPLICATION

(11) **EP 2 460 783 A1**
(43) Date of publication of application: **06.06.2012**
(21) Application number: 10804554.3
(22) Date of filing: 30.07.2010
(51) Int. Cl.: C04B 38/00, C04B 35/111, H01L 33/48

(54) **CERAMIC SUBSTRATE FOR MOUNTING LUMINESCENT ELEMENT**

(30) Priority: 31.07.2009 JP 2009178864; 27.08.2009 JP 2009196350
(71) Applicant: Kyocera Corporation, Kyoto-shi, Kyoto 612-8501 (JP)
(72) Inventor: UCHINO,Kazuhito, Satsumasendai-shi Kagoshima 895-0292 (JP); NISHIMOTO,Kenichi, Satsumasendai-shi Kagoshima 895-0292 (JP)
(74) Representative: Beetz & Partner
(86) International application number: PCT/JP2010/062918
(87) International publication number: WO 2011/013808

(57) **Abstract**

[Problem] A ceramic substrate for mounting a luminescent element which has high reflectivity of 90% or above in ultraviolet to infrared regions (350 nm to 1,000 nm) and which has satisfactory mechanical properties.

[Solution] A ceramic substrate (1) for mounting a luminescent element includes a content of aluminum oxide of from 94 mass% to 97 mass%, silicon oxide, and at least one of calcium oxide and magnesium oxide. The ceramic substrate (1) has a porosity of from 2.5% to 4.5%, a number of pores of from 7,000 to 11,000, and a cumulative relative frequency of 70% or above in an equivalent circle diameter of 1.6 µm or less in a pore distribution, when viewing pores having an equivalent circle diameter of 0.8 µm or more in a surface area portion of 9.074×10⁵ µm² of a surface (1a) of the substrate (1). The ceramic substrate (1) has high reflectivity of 90% or above in ultraviolet to infrared regions and has satisfactory mechanical properties, which is suitable for use in a luminescent device (21).

## Description

### Technical Field

The present invention relates to a ceramic substrate for mounting a luminescent element, for placing a luminescent element such as LED.

### Background Art

In recent years, LED (light emitting diode) is noted as a luminescent element capable of mass production, having high brightness and having low power consumption. Furthermore, LED is increasingly utilized widely as light sources for general lightings, light sources for liquid crystal display panels, and backlights of image displays using liquid crystal such as mobile phones, personal computers and televisions.

A substrate for mounting the luminescent element is required to have insulating property for the reason that an electrode is formed on the surface thereof. Furthermore, a substrate having a reflective material coated thereon likely gives rise to the disadvantages that the reflective material discolors by the change with the passage of time, resulting in decreasing reflectivity, and the reflective material is peeled from the substrate by the generation of heat of a luminescent element. Accordingly, the substrate is required to have a high reflectance by itself.

To meet the above requirements, Patent Literature 1 discloses using an aluminum nitride sintered compact as a ceramic substrate for mounting a light emitting element.

Patent Literature 2 proposes a package for light emitting element accommodation containing from 74.6% to 100 mass% alumina as a light reflecting material, and barium carbonate as other component, the content of alumina having an average particle size of 2.5 µm or less after sintering being 74.6 mass%.

Patent Literature 3 discloses high reflection white ceramics, wherein a high reflection white ceramic substrate for a semiconductor light emitting element is made of aluminum oxide and a glassy component, and porosity is 5% or below. Patent Literature 3 further discloses high reflection white ceramics is made of aluminum oxide and a glassy material, wherein the content of the aluminum oxide is from 75 wt% to 85 wt%, the glassy material contains silica, calcium, magnesium and barium, and the crystal particle size of the aluminum oxide is 0.5 µm or less.

Patent Literature 4 discloses that a frame surrounding a light emitting element mounting part has a thickness of 0.8 mm or more, and in the case that the frame is made of an aluminum oxide sintered compact, when the alumina content is from 90 wt% to 99 wt% and the total content of SiO₂, MgO and CaO is from 1 wt% to 10 wt%, reflectivity of light having a wavelength of from 400 nm to 700 nm can be 80% or above.

### Citation List

### Patent Literature

Patent Literature 1: WO2007/034955
Patent Literature 2: WO2007/058361
Patent Literature 3: Japanese Unexamined Patent Publication JP-A 2007-284333
Patent Literature 4: Japanese Unexamined Patent Publication JP-A 2004-207678

### Summary of Invention

### Technical Problem

However, the ceramic substrate for mounting a light emitting element made of aluminum nitride disclosed in Patent Literature 1 does not disclose reflectivity of a region of from visible light having long wavelength to infrared ray, and still had a problem that aluminum nitride which is a main component is expensive.

The package for light emitting element accommodation disclosed in Patent Literature 2 had the problem that when the alumina content is 100 mass%, a sintering temperature is increased. The problem still remained that where the amount of barium carbonate added as an additive to decrease the sintering temperature is increased, costs are increased.

The high reflection white ceramic substrate for a semiconductor light emitting element disclosed in Patent Literature 3 still had the problem that a high reflection white ceramic substrate having a reflectivity at a wavelength of from 450 nm to 750 nm of 90% or above is obtained, but the substrate contains expensive barium in an amount of 3 wt% as shown in the Examples, resulting in the increase in costs.

The package for light emitting element accommodation disclosed in Patent Literature 4 does not describe that the reflectivity of ceramic used in the package is due to inner pores of the ceramics.

The invention has been made to solve the above problems, and an object thereof is to provide a ceramic substrate for mounting a luminescent element, in which costs of manufacturing a ceramic sintered compact to become a substrate is lowered and high reflectivity as a substrate for mounting a luminescent element is obtained.

### Solution to Problem

A ceramic substrate for mounting a luminescent element according to the invention includes a content of aluminum oxide of from 94 mass% to 97 mass%; silicon oxide; and at least one of calcium oxide and magnesium oxide, wherein the ceramic substrate has a porosity of from 2.5% to 4.5%, a number of pores of from 7,000 to 11,000, and a cumulative relative frequency of 70% or above in an equivalent circle diameter of 1.6 µm or less in a pore distribution, when viewing pores having an equivalent circle diameter of 0.8 µm or more in a surface area portion of 9.074×10⁵ µm² of a surface of the substrate.

### Advantageous Effects of Invention

According to the ceramic substrate for mounting a luminescent element of the invention, the ceramic substrate includes a content of aluminum oxide of from 94 mass% to 97 mass%; silicon oxide; and at least one of calcium oxide and magnesium oxide, wherein the substrate has a porosity of from 2.5% to 4.5%, a number of pores of from 7,000 to 11,000, and a cumulative relative frequency of 70% or above in an equivalent circle diameter of 1.6 µm or less in a pore distribution, when viewing pores having an equivalent circle diameter of 0.8 µm or more in a surface area portion of 9.074×10⁵ µm² of a surface of the substrate. Accordingly, even though light from the luminescent element enters the inside of the substrate without reflecting on the surface of the substrate, the presence of the pores having the porosity, the number of pores and the pore distribution described above increases reflected light in the inside of the substrate, thereby making it easy to improve the reflectivity of the substrate.

### Brief Description of Drawings

Fig. 1 is a sectional view showing one example of the constitution of a luminescent device having a luminescent element placed on a ceramic substrate for mounting a luminescent element according to an embodiment;
Fig. 2 is a conceptual view showing a state that incident light to a surface of the ceramic substrate for mounting a luminescent element according to the embodiment scatters; and
Fig. 3 is a cross-sectional view showing a measurement method of adhesion strength to a conductor adhered to the surface of the ceramic substrate for mounting a luminescent element according to the embodiment.

### Description of Embodiments

Embodiment of a ceramic substrate for mounting a luminescent element according to the invention is described below.

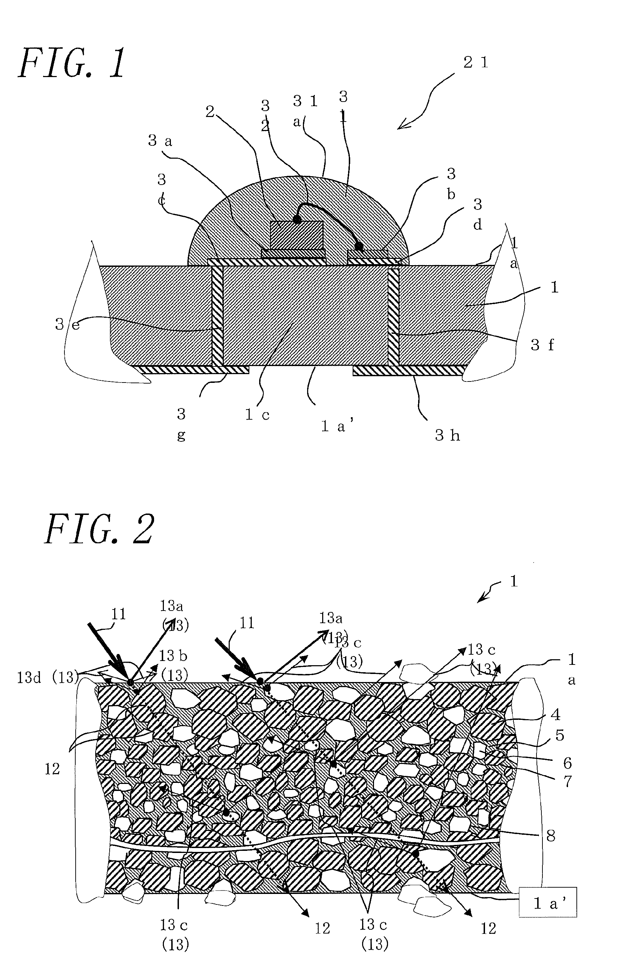

Fig. 1 is a sectional view showing one example of the constitution of a luminescent device having a luminescent element placed on a ceramic substrate for mounting a luminescent element according to the embodiment.

A luminescent device 21 using a ceramic substrate 1 for mounting a luminescent element (hereinafter referred to as "substrate 1") of the embodiment is that electrodes (front electrodes) 3c and 3d for a cathode electrode and an anode electrode are deposited on one surface 1a of the substrate 1 on which a luminescent element 2 is mounted, using thick film printing, electrode pads 3a and 3b are formed by plating or the like on a part having the electrodes 3c and 3d formed thereon, and the luminescent element 2 made of a semiconductor is placed on the electrode pad 3a. An anode electrode (not shown) or a cathode electrode (not shown) of the luminescent element 2 is electrically connected to the electrode pad 3b by a bonding wire 32. The connection between the electrode pad 3a and the luminescent element 2 may be connection using a conductive adhesive, connection by the bonding wire 32 or connection by solder bump so long as those can electrically be connected. The luminescent element 2 and electrodes 3c and 3d including the electrode pads 3a and 3b are covered with an encapsulating member 31 made of a resin or the like, and the encapsulating member 31 has both protection of the luminescent element 2 and function of a lens 31a. A transparent overcoat glass is generally deposited as a protective layer on exposed parts of the electrodes 3c and 3d and the pad electrodes 3a and 3b, but the description of the protective layer is omitted in the embodiment.

The electrodes (front electrodes) 3c and 3d are electrically connected to electrodes (back electrodes) 3g and 3h formed on other surface 1a' of the substrate 1 through electrodes (through conductive layers) 3e and 3f penetrating the substrate 1.

External direct current power source (not shown) or AC-DC switching power source (not shown) is connected to the electrodes (back electrodes) 3g and 3h, and by applying positive voltage to a cathode electrode side and negative voltage to an anode electrode side, P-N junction of the luminescent element 2 emits light. In this case, the encapsulating member 31 has the functions of not only protecting the luminescent element 2, but selectively converting a wavelength of light in many cases, and has a structure of diffusing and emitting light from the lens 31a which is an outer shell of the encapsulating member 31.

The composition of the ceramic substrate 1 for mounting a luminescent element of the embodiment is that the aluminum oxide content is from 94 mass% to 97 mass%, and silicon oxide and at least one of calcium oxide and magnesium oxide are contained. Furthermore, it is important that when viewing pores having an equivalent circle diameter of 0.8 µm or more in a portion having a surface area of 9.074×10⁵ µm² on the surface of the ceramic substrate 1 for mounting a luminescent element, a porosity by pores having an equivalent circle diameter of 0.8 µm or more is a range of from 2.5% to 4.5%, a number of pores having an equivalent circle diameter of 0.8 µm or more is a range of from 7,000 to 11,000, and a cumulative relative frequency of an equivalent circle diameter of 1.6 µm or less in a pore distribution of pores having an equivalent circle diameter of 0.8 µm or more is 70% or above.

Fig. 2 is a conceptual view showing a state that incident light to the surface of the ceramic substrate for mounting a luminescent element according to the embodiment scatters.

As shown in Fig. 2, when viewing the cross-section in a level of a size of a crystal, the ceramic substrate 1 for mounting a luminescent element of the embodiment has alumina particles 4, a glass phase (grain boundary phase) 5 made of silicon oxide or the like, and pores 6. The portion between the alumina particles 4 and the glass phase is indicated as an interface 7, and the portion between the pores 6 and the glass phase 5 is indicated as an interface 8.

Incident light 11 emitted to the surface 1a of the ceramic substrate 1 for mounting a luminescent element of the embodiment becomes reflected light 13 reflected by the substrate 1, and transmitted light 12 from the other surface 1a' opposite the one surface 1a to which the incident light 11 has been emitted, by passing through the inside of the substrate 1.

Furthermore, a part of the incident light 11 becomes regularly reflected light 13a reflected in a reverse direction with the same angle to the incident angle on the surface 1a, and diffusely-reflected light 13d reflected in an indefinite direction on the surface 1a, and the remaining light enters the substrate 1 and becomes transmitted light 12 transmitting at least any one of the alumina particles 4, pores 6 and the glass phase 5. A part of the transmitted light 12 becomes diffusely-reflected light 13b at the interface 7 between the alumina particles 4 and the glass phase 5 in the substrate 1, and further becomes diffusely-reflected light 13c at the interface 8 between the pores 6 and the glass phase 5. The remaining light progresses in the substrate 1 as the transmitted light 12, generates diffusely-reflected lights 13b and 13c at the interface 7 between the alumina particles 4 and the glass phase 5 and at the interface 8 between the pores 6 and the glass phase 8, and becomes reflected light 13 from the surface 1a. A part of the light comes out as the transmitted light 12 from the other surface 1a'.

To improve reflectivity of light, it is most preferred that the incident light 11 emitted to the surface 1a of the substrate 1 becomes the regularly reflected light 13a and the diffusely-reflected light 13d on the surface 1a. This greatly increases the number of the pores 6 present at the surface side as compared with the conventional ceramic substrate for mounting a luminescent element, and further increases the number of pores 6 existed toward the central part side, thereby the opportunity of generation of the diffusely-reflected light 13c in the transmitted light 12 is increased at the interface 8 between the pores 6 and the glass phase 5. As a result, the reflected light 13 from the surface 1a can be increased, and the reflectivity becomes easy to be increased.

The ceramic substrate 1 for mounting a luminescent element of the embodiment is that the content of aluminum oxide as the main component is a range of from 94 mass% to 97 mass%. Therefore, the total content of silicon oxide and at least one of calcium oxide and magnesium oxide, excluding unavoidable impurities, is from 3 mass% to 6 mass% as the remainder. Even though barium having high material cost is not used and the ceramic substrate is fired at a temperature of from 1,420°C to 1,540°C which is a temperature lower than the general firing temperature, sinterability is sufficiently increased, and this can reduce cost of the substrate 1. It is not always inhibited to contain barium.

The glass phase 5 made of silicon oxide or the like is formed between the alumina particles 4. Therefore, when a thick film paste for forming the electrodes 3c and 3d is applied to the one surface 1a of the substrate 1, on which the luminescent element 2 is mounted, and is subjected to thick film firing, metal components contained in the paste propagates through the glass phase 5 from the surface 1a and diffuses inside. Therefore, adhesion strength between the electrodes 3c and 3d and the substrate 1 is easy to be increased.

Furthermore, when viewing pores having an equivalent circle diameter of 0.8 µm or more in a portion having a surface area of 9.074×10⁵ µm² on the surface 1a of the substrate 1, on which the luminescent element 2 is placed, a porosity is from 2.5% to 4.5%, and the number of pores is from 7,000 to 11,000. This constitution can increase the number of pores without increasing the porosity and spread the area of the interface 8 between the glass phase 5 and the pores 6. As a result, as described using Fig. 2, the regularly reflected light 13a and the diffusely-reflected light 13d, on the surface 1a of the substrate 1, and the diffusely-reflected lights 13b and 13c in the substrate 1 are increased, thereby the incident light 11 can be reflected outside the surface 1a at the side that the incident light 11 enters. Furthermore, when the light which propagates through the alumina particles 4 in the substrate 1 and intends to transmit to the other surface side 1a' side transmits through the glass phase 5, more light can be diffusely-reflected at the interface 8 between the glass phase 5 and the pores 6 by that the porosity and the number of pores have the ranges of the embodiment. As a result, light transmitted and came out from the surface 1a' opposite the side that the incident light 11 enters is decreased, the reflected light 13 emitted to the surface 1a becomes easy to greatly increase, and the reflectivity of the substrate can make easy to be increased. For this reason, expensive barium is not required to use, and the reflectivity can be easy to increase.

When viewing pores having an equivalent circle diameter of 0.8 µm or more in a portion having a surface area of 9.074×10⁵ µm² on the surface 1a of the substrate 1, on which the luminescent element 2 is placed, a cumulative relative frequency of an equivalent circle diameter of 1.6 µm or less in a pore distribution is 70% or above. This constitution makes easy to reduce the decrease in mechanical strength due to the presence of large pores 6, can spread the area of the interface 8 between the glass phase 5 and the pores 6. As a result, the reflected light 13 is easy to be increased.

The number of the pores 6 in a portion having a surface area of 9.074×10⁵ µm² on the surface 1a of the ceramic substrate 1 for mounting a luminescent element according to the embodiment is more preferably from 9,000 to 11,000 at which both mechanical properties and reflectivity become best, and the cumulative relative frequency of an equivalent circle diameter of 1.6 µm or less in a pore distribution of an equivalent circle diameter of 0.8 µm or more is more preferably 75% or above. The sintering temperature is from about 1,420°C to 1,540°C, the firing time is a range of from 3.6 to 21 hours, temperature variation in a firing furnace is suppressed such that a sintered compact to become the substrate 1 is more uniformly sintered, the number of molded bodies piled is decreased, and temperature profile of temperature rising and temperature lowering is severely controlled. As a result, a sintered compact to become the substrate 1 can be obtained.

The measurements of an average pore size, the number of pores, porosity and pore distribution of the pores 6 are as follows. The surface 1a of a sample of the substrate 1 is mirror polished to a depth of, for example, 10 µm. Image of a metal microscope with 100-fold magnification is taken in CCD camera, and analyzed with an image analyzer to quantify. Specifically, Model Win ROOF manufactured by Mitani Corporation is used as an image analysis software. To the surface area of 9.074×10⁵ µm², an equivalent circle diameter 0.8 µm is used as a threshold, and each measurement value is calculated.

Measurement of reflectivity of light is as follows. Spectrophotometer (for example, spectrophotometer Model UV-315 manufactured by Shimadzu Corporation, and its attachment, integrating sphere unit Model ISR-3100) is used, 50W halogen lamp and deuterium lamp are used as a light source, a wavelength range is from 200 nm to 1,000 nm, the measurement range is diffuse reflectance (7x9 mm at slit 20 nm), mask is not used, and barium sulfate powder is used as a standard.

When viewing pores having an equivalent circle diameter of 0.8 µm or more, in the ceramic substrate 1 for mounting a luminescent element of the embodiment, it is preferable that the number of pores at the central part side of the substrate 1 is larger than that at the surface side thereof.

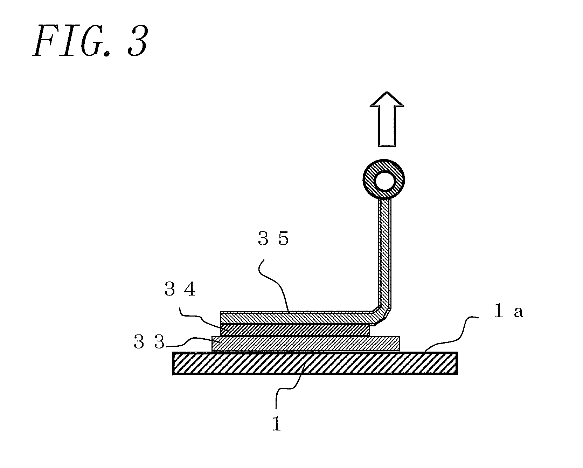

The surface side and the central part side of the ceramic substrate 1 for mounting a luminescent element of the embodiment are described below. The surface side is that a portion of the surface layer up to about 10 µm in a thickness direction from the one surface 1a or the other surface 1a' of the substrate 1 shown in Fig. 3 is designated as a surface side. In a substrate made of alumina for general thick film paste printing (commonly called a thick film substrate), a depth that a metal component as a conductor penetrates inside from the surface of an alumina substrate together with a component for adhering a conductor (for example, bismuth) added in a paste is about 10 µm. From this fact, the surface layer in this range is designated as a surface side. The central part side means a center part when the substrate 1 is split evenly into thirds in a thickness direction.

When the porosity is from 2.5% to 4.5% and the number of pores is from 7,000 to 11,000 when viewing pores having an equivalent circle diameter of 0.8 µm or more in a portion having a surface area of 9.074×10⁵ µm² on the surface 1a of the substrate 1, on which the luminescent element 2 is mounted, and when the number of pores at the central part side of the substrate 1 is larger than that at surface side thereof when viewing pores 6 having an equivalent circle diameter of 0.8 µm or more in a portion having a surface area of 9.074×10⁵ µm² on the surface 1a, a part of the light during transmitting inside from the surface 1a of the substrate 1 becomes diffusely-reflected lights 13b and 13c at the interface 7 between the alumina particles 4 and the glass phase 5 and at the interface 8 between the pores 6 and the glass phase 5, and the remaining light becomes transmitting light and progresses. However, the number of pores is increased than that at the surface sides with approaching the central part side of the substrate 1. As a result, the area of the interface 8 between the pores 6 and the glass phase 5 becomes wide, and occurrence frequency of the diffusely-reflected light 13c is increased. Therefore, the reflected light 13 emitted to the surface 1a is increased.

The relationship of the number of pores is equivalent between the both surface sides and the central part side of the ceramic substrate 1 for mounting a luminescent element of the embodiment. Therefore, for example, the luminescent element 2 may be mounted on either of the surfaces 1a and 1a'. As a result, it is not necessary to consider the directionality of the front and back of the substrate 1, and productivity can be improved.

In the ceramic substrate 1 for mounting a luminescent element of the embodiment, it is preferable that the content of silicon oxide is from 1 mass% to 3 mass%.

When the content of silicon oxide is from 1 mass% to 3 mass%, the glass phase 5 is sufficiently formed in the grain boundary between alumina particles 4 excluding the pores 6 as shown in Fig. 2. Furthermore, the surfaces 1a and 1a' are sintered at a temperature of from 1,420°C to 1,540°C which is lower than the ordinary firing temperature to an extent free of problem as a substrate for electronic parts. As a result, mechanical strength as the substrate 1 can be secured.

Electrodes 3c, 3d, 3g and 3h as shown in Fig. 1, as well as the cathode electrode and anode electrode for mounting the luminescent element 2 are formed on the surfaces 1a and 1a' of the substrate 1. When those electrodes are formed by applying a thick film paste, followed by thick film firing, the metal contained in the paste moves through the glass phase 5 from the surfaces 1a and 1a' of the substrate 1, diffuses inside and is fired, thereby a printed electrode 3 becomes easy to be strongly adhered to the surfaces 1a and 1a' of the substrate 1. In this case, where the content of silicon oxide is less than 1 mass%, the sufficient glass phase 5 is not formed between the alumina particles 4. As a result, the metal contained in the electrode 3 does not sufficiently diffuse in the glass phase 5 from the surfaces 1a and 1a', and adhesion strength of the electrode 3 becomes easy to be decreased.

Where the content of silicon oxide exceeds 3 mass%, the proportion of the glass phase 5 is increased. As a result, mechanical strength (bending strength) and hardness become easy to be decreased. Furthermore, there is a possibility that abnormal crystals such as mullite crystallize. Those crystallized products may cause the decrease in electrical characteristics. Therefore, the content of silicon oxide is preferably from 1 mass% to 3 mass% as a substrate for electronic parts.

Further, in the ceramic substrate 1 for mounting a luminescent element of the embodiment, it is preferable that the average pore size of the pores in the surfaces 1a and 1a' is from 0.1 to 1.95 µm.

As shown in Fig. 2, a part of the incident light 11 emitted to the one surface 1a of the substrate 1 becomes the reflected light 13 reflected by the substrate 1, and a part of the incident light 11 passes through the inside of the substrate 1 and becomes the transmitted light 12 from the other surface 1a' of the substrate 1 opposite the surface 1a to which the incident light 11 has been emitted.

According to the ceramic substrate 1 for mounting a luminescent element of the embodiment, the same diffusely-reflected light 13c as the diffusely-reflected light 13b generated at the interface 7 between the alumina particles 4 and the glass phase 5 is generated at the interface 8 between the pores 6 and the glass phase 5. It is therefore considered that the opportunity of emitting the reflected light 13 to the outside of the substrate 1 is markedly increased, thereby the reflectivity of light is improved.

It is further considered that when the average pore size of the pores 6 is in a range from 1.0 µm to 1.95 µm, the diffusely-reflected light 13b and the diffusely-reflected light 13c are suitably generated in the substrate 1, and additionally, the opportunity that those lights are emitted outside from the surface 1a of the substrate 1 is increased.

Next, one example of the method for manufacturing the ceramic substrate for mounting a luminescent element of the embodiment is described below.

A powder of aluminum oxide (Al₂O₃) having an average particle size of from about 1.4 µm to 1.8 µm, silicon oxide (SiO₂), and at least one powder of calcium oxide (CaO) and magnesium oxide (MgO), for manufacturing the ceramic substrate 1 for mounting a luminescent element are prepared. A powder mixture prepared by weighing such that the total content of the powders becomes 100 mass% is introduced in a rotary mill together a solvent such as water, followed by mixing. To the resulting mixture, one molding binder selected from polyvinyl alcohol, polyethylene glycol, acrylic resin and butyral resin is added in an amount of from about 4 mass% to 8 mass% based on 100 mass% of the powder mixture. The resulting mixture is mixed with a rotary mill using high purity alumina balls to obtain a slurry. Using the slurry, a sheet is molded by a doctor blade method, or a granulated body is prepared from the slurry using a spray drier, and using the granulated body, a sheet is molded by a roll compaction method. Unfired compact is prepared by processing using a mold for product shape, or laser processing. In this case, the compact may be a single article of the substrate 1 on which a luminescent element is finally mounted, but considering mass productivity, the compact for obtaining a plurality of substrates is more preferred. The compact obtained is fired by setting such that the maximum temperature becomes from 1,420°C to 1,540°C using a firing furnace of air (oxidizing) atmosphere (for example, roller type tunnel furnace, batch type atmosphere furnace or pressure type tunnel furnace). Thus, the ceramic substrate 1 for mounting a luminescent element of the embodiment can be manufactured. The number of pores can be increased and decreased by changing the firing time.

### Example 1

Examples of the invention are specifically described below, but the invention is not limited to the Examples.

A powder having an average particle size of about 1.6 µm as aluminum oxide (Al₂O₃), silicon oxide (SiO₂), and at least one powder of calcium oxide (CaO) and magnesium oxide (MgO) are prepared. A powder mixture prepared by weighing such that the total content of the powders becomes 100 mass% is introduced in a rotary mill together a solvent such as water, followed by mixing.

Then, to the resulting mixture, a molding binder of an acrylic resin is added, and the resulting mixture is further mixed with a high purity alumina ball and then a rotary mill to obtain a slurry. The amount of the molding binder added is from about 4 mass% to 8 mass% based on 100 mass% of the powder mixture. The addition amount in this range does not give rise to the problem in strength and flexibility of a compact. Furthermore, the disadvantage due to that degreasing of the molding binder becomes insufficient during firing does not occur.

Then, the slurry obtained is molded into a sheet by the conventional doctor blade method, and the sheet is processed into a size of a product shape with a mold.

Then, to sinter the product-shaped compact, firing is conducted in a pressure type tunnel furnace under the temperature conditions shown in Table 1. Thus, samples (Samples Nos. 1 to 33) of ceramic substrates for mounting a luminescent element shown in Table 1, in which the thickness of the substrate 1 is 0.635 mm, were obtained. The firing time is 9 hours in Sample Nos. 1 to 23, and Sample Nos. 24 to 33 are fired by changing the firing time in a range of from 3.6 to 21 hours.

Porosity, the number of pores, cumulative relative frequency of pore distribution, bending strength, adhesion strength of a conductor, and refractivity were measured by the following methods on the samples of the ceramic substrate for mounting a luminescent element obtained.

The measurement of porosity, the number of pores, and cumulative relative frequency of pore distribution of the substrate 1 is as follows. The surface of each sample is mirror polished to a depth of 10 µm from the surface. Image of a metal microscope with 100-fold magnification is taken in CCD camera, and quantified using an image analyzer. Specifically, a microscope Model VHX-500 manufactured by Keyence was used as the metal microscope, digital SIGHT Model DS-2Mv manufactured by Nikon Corporation was used as the CCD camera, and Model Win ROOF manufactured by Mitani Corporation was used as an image analysis software. To the surface area of 9.074×10⁵ µm², an equivalent circle diameter 0.8 µm was used as a threshold, and each measurement value was calculated. The number of measurement is one per each sample, and the measurement area in every measurement is 2.2685×10⁵ µm². Four places were measured, and data to the surface area in which the total measurement area is 9.074×10⁵ µm² were obtained. When the number of pores is calculated using other apparatus, the value obtained by converting the number of pores per the measurement area into the number of pores per 9.074×10⁵ µm² should be from 7,000 to 11,000.

A sintered compact having a length of 30 mm, a width of 10 mm and a thickness of 0.8 mm was previously prepared according to JIS R 1601 under the same composition and the same firing conditions as the above each sample. Load of 0.5 mm/min was applied to a central part in which a span of the sintered compact is 20 mm, the maximum load until the sintered compact broke was measured, and three-point bending strength was calculated. The measurement was conducted on 10 samples, and its average value was obtained.

Fig. 3 is a cross-sectional view showing a measurement method of adhesion strength to a conductor adhered to the surface of the ceramic substrate for mounting a luminescent element according to the embodiment.

As shown in Fig. 3, the measurement method of adhesion strength to a conductor 33 adhered to the surface of the ceramic substrate 1 is as follows. A thick film paste (not shown) was printed on the surface 1a of the substrate 1 which is a material to be measured to form the conductor 33 made of silver palladium (Model TR4846, manufactured by Tanaka Kikinzoku Kogyo) having a size of 2 mm square and a thickness of 10 µm after firing, followed by firing at about 850°C. A plated conductive wire (copper wire plated with Sn) 35 having a diameter of 0.6 mm was soldered on the surface of the conductor 33 at a temperature of 225±5°C using an Sn-Pb (6:4 solder) type solder 34 containing Ag in an amount of 2wt% based on the mass of the solder and using a flux prepared by mixing ketone and an alcohol solvent with a rosin synthetic resin, trade name: XA-100 (manufactured by Tamura Kaken Corporation). Thus, a measurement sample was prepared. The plated conductive wire was pulled at a rate of 7.62 mm/min, and strength at which the conductor 33 was peeled from the substrate 1 was measured. This value was used as adhesion strength of the conductor to the substrate 1. The test apparatus used was Die Sharing Tester (Model 520D, manufactured by ANZA TECH). Ten samples were measured for each sample, and its average value was obtained. In the case that the plated copper wire 35 was peeled from the conductor 33, the case was excluded from the data, and the data only when the conductor 33 was peeled from the substrate 1 were used as adhesion strength.

Then, the reflectivity was measured as follows. Spectrophotometer Model UV-315 and integrating sphere Model ISR-3100, manufactured by Shimadzu Corporation were used as a measuring instrument (not shown), 50W halogen lamp and deuterium lamp were used as a light source, a wavelength range was from 200 nm to 1,000 nm, the measurement range was diffuse reflectance (7x9 mm at slit 20 nm), filter and mask was not used, and barium sulfate powder was used as a standard. The number of the measuring sample was each one sample having a thickness of the substrate 1 of 0.635 mm, and the reflectivity was measured on one site of the surface 1a of each one sample.

Sample Nos. 3 to 7, 9, 10, 12, 13 and 15 to 33 are Examples of the ceramic substrate 1 for mounting a luminescent element of the embodiment, and Sample Nos. 1, 2, 8, 11 and 14 are Comparative Examples.

Comprehensive evaluation of each sample is that a sample satisfying that bending strength is 310 MPa or more, adhesion strength of the conductor 33 is 19 MPa or more and reflectivity at a wavelength in a range of from 350 nm to 1,000 nm is 90% or above is considered "Acceptable", and a sample which does not satisfy at least one of the above items is considered "Unacceptable".

The results obtained are shown in Table 1 and Table 2.

**Table 1**

| Sample No. | Composition and content of substrate | | | | Total amount of second component | Firing temperature | Firing time |
|---|---|---|---|---|---|---|---|
| | Al₂O₃ | SiO₂ | CaO | MgO | | | |
| | (mass%) | (mass%) | (mass%) | (mass%) | (mass%) | (°C) | (hour) |
| 1 | 96.00 | 2.50 | 0.30 | 1.20 | 4.00 | 1550 | 9.0 |
| 2 | 93.50 | 3.50 | 0.60 | 2.40 | 6.50 | 1530 | 9.0 |
| 3 | 94.00 | 3.00 | 0.60 | 2.40 | 6.00 | 1530 | 9.0 |
| 4 | 95.00 | 2.75 | 0.45 | 1.80 | 5.00 | 1530 | 9.0 |
| 5 | 96.00 | 2.50 | 0.30 | 1.20 | 4.00 | 1530 | 9.0 |
| 6 | 96.00 | 2.50 | 0.00 | 1.50 | 4.00 | 1530 | 9.0 |
| 7 | 96.00 | 2.50 | 1.50 | 0.00 | 4.00 | 1530 | 9.0 |
| 8 | 96.00 | 4.00 | 0.00 | 0.00 | 4.00 | 1530 | 9.0 |
| 9 | 96.50 | 1.50 | 0.40 | 1.60 | 3.50 | 1530 | 9.0 |
| 10 | 97.00 | 1.00 | 0.40 | 1.60 | 3.00 | 1530 | 9.0 |
| 11 | 97.50 | 0.50 | 0.40 | 1.60 | 2.50 | 1530 | 9.0 |
| 12 | 96.00 | 2.50 | 0.30 | 1.20 | 4.00 | 1500 | 9.0 |
| 13 | 96.00 | 2.50 | 0.30 | 1.20 | 4.00 | 1450 | 9.0 |
| 14 | 96.00 | 2.50 | 0.30 | 1.20 | 4.00 | 1400 | 9.0 |
| 15 | 94.00 | 3.75 | 0.00 | 2.25 | 6.00 | 1510 | 9.0 |
| 16 | 94.00 | 3.75 | 2.25 | 0.00 | 6.00 | 1510 | 9.0 |
| 17 | 94.00 | 3.75 | 0.00 | 2.25 | 6.00 | 1450 | 9.0 |
| 18 | 94.00 | 3.75 | 2.25 | 0.00 | 6.00 | 1450 | 9.0 |
| 19 | 97.00 | 1.87 | 0.00 | 1.13 | 3.00 | 1530 | 9.0 |
| 20 | 97.00 | 1.87 | 1.13 | 0.00 | 3.00 | 1530 | 9.0 |
| 21 | 97.00 | 1.87 | 0.00 | 1.13 | 3.00 | 1450 | 9.0 |
| 22 | 97.00 | 1.87 | 1.13 | 0.00 | 3.00 | 1450 | 9.0 |
| 23 | 94.00 | 3.00 | 0.60 | 2.40 | 6.00 | 1510 | 9.0 |
| 24 | 94.00 | 3.00 | 0.60 | 2.40 | 6.00 | 1400 | 18.0 |
| 25 | 94.00 | 3.00 | 0.60 | 2.40 | 6.00 | 1540 | 4.5 |
| 26 | 94.00 | 3.00 | 0.60 | 2.40 | 6.00 | 1500 | 6.0 |
| 27 | 94.00 | 3.00 | 0.60 | 2.40 | 6.00 | 1400 | 7.5 |
| 28 | 97.00 | 1.88 | 0.22 | 0.90 | 3.00 | 1540 | 4.5 |
| 29 | 97.00 | 1.88 | 0.22 | 0.90 | 3.00 | 1510 | 6.0 |
| 30 | 97.00 | 1.88 | 0.22 | 0.90 | 3.00 | 1430 | 21.0 |
| 31 | 97.00 | 1.88 | 0.22 | 0.90 | 3.00 | 1550 | 3.6 |
| 32 | 97.00 | 1.88 | 0.22 | 0.90 | 3.00 | 1490 | 4.8 |
| 33 | 97.00 | 1.88 | 0.22 | 0.90 | 3.00 | 1420 | 6.0 |

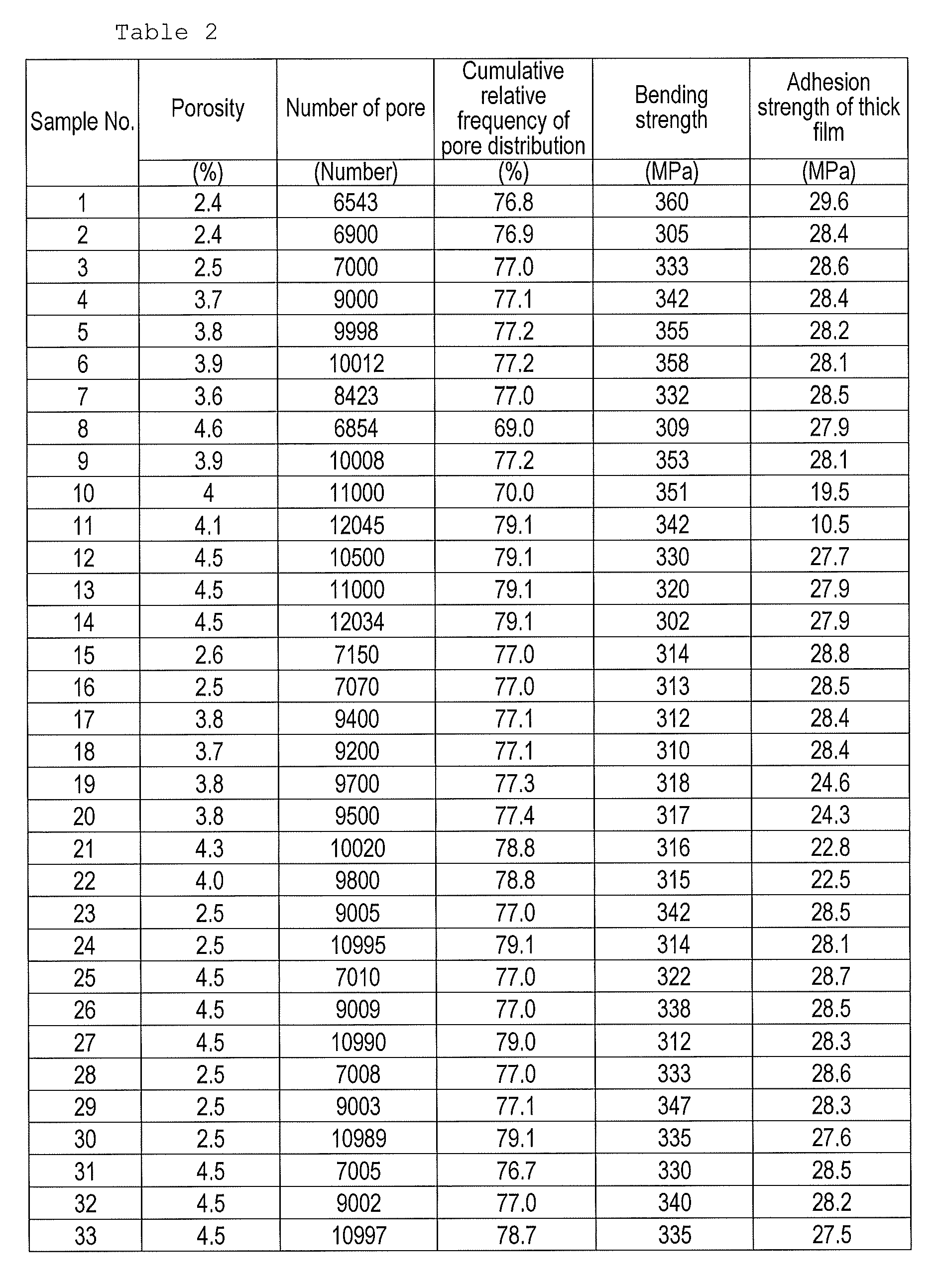

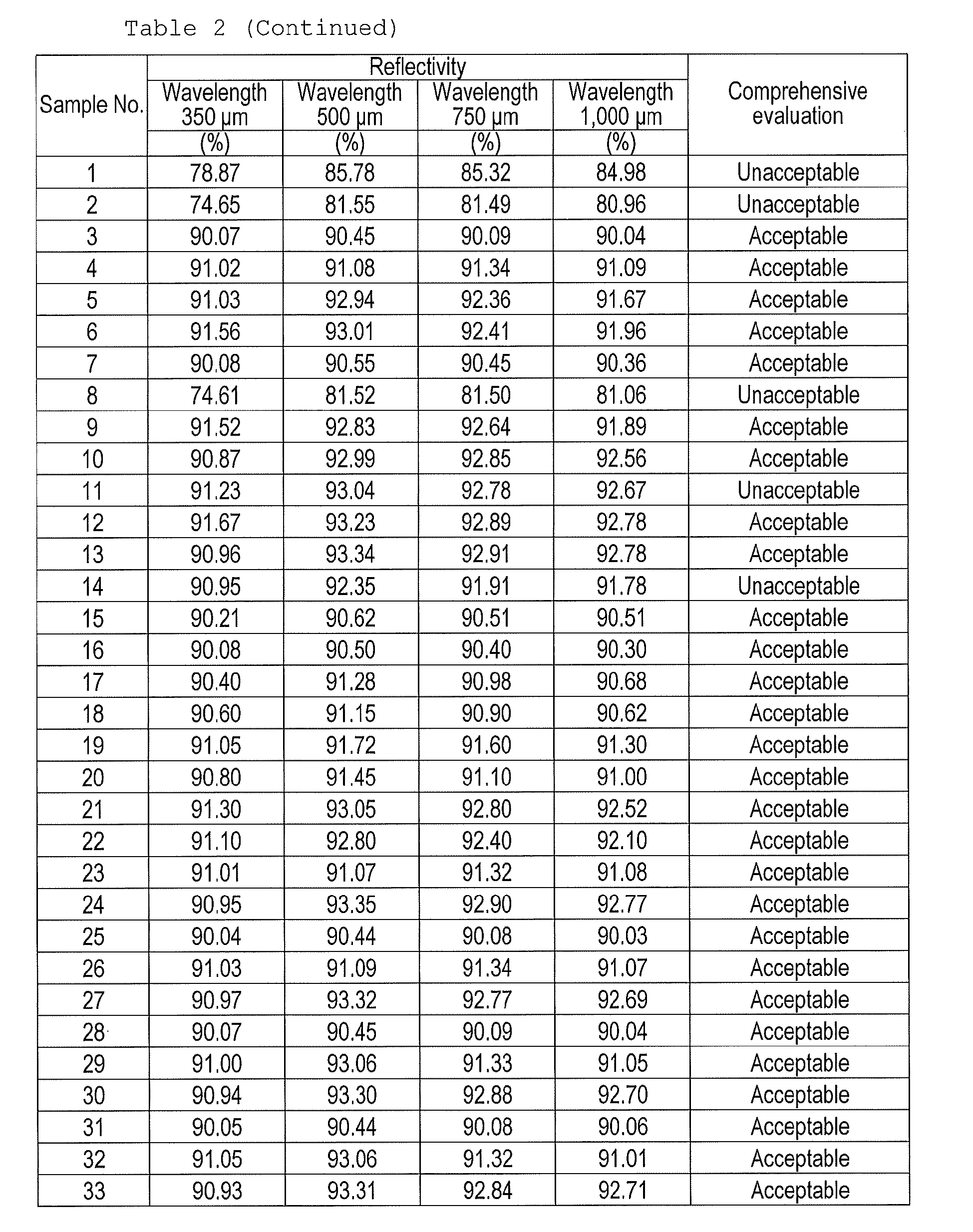

As is seen from the results shown in Tables 1 and 2, Sample Nos. 1, 2, 8, 11 and 14 of the Comparative Examples did not satisfy at least one item in the items of the comprehensive evaluation, and was considered "Unacceptable".

Sample No 1 was that because the firing temperature was high, the porosity and the number of pores were decreased, and the reflectivity was less than 90%. Sample No. 2 was that because the content of aluminum oxide was low as 93.5% and the total content of silicon oxide which is a second component and at lest one of calcium oxide and magnesium oxide was large, the porosity and the number of pores were decreased, and the reflectivity was low as less than 90% in any wavelength range. Sample No. 8 does not contain calcium oxide and magnesium oxide. Therefore, it is seen that growth of crystal particles during sintering cannot be inhibited, the porosity is increased, the number of pores is decreased, the reflectivity is low as less than 90% in any wavelength range, and bending strength is low value as compared with other samples.

Further, Sample No. 11 was that because the content of silicon oxide was small as 0.5 mass%, adhesion strength of the conductor 33 was low as 10.5 MPa. Sample No. 14 showed the results that because the firing temperature was further low, sintering of alumina particles was insufficient, the number of pores was increased, and although the reflectivity in each wavelength range was high, the bending strength was slightly low.

On the other hand, Sample Nos. 3 to 7, 9, 10, 12, 13 and 15 to 33 which are the Examples of the invention are ceramic substrates for mounting a luminescent element, containing a content of aluminum oxide of from 94 mass% to 97 mass%, silicon oxide, and at least one of calcium oxide and magnesium oxide, the ceramic substrate having a porosity of from 2.5% to 4.5%, the number of pores of from 7,000 to 11,000, and a cumulative relative frequency of 70% or above in an equivalent circle diameter of 1.6 µm or less in a pore distribution, when viewing pores having an equivalent circle diameter of 0.8 µm or more in a surface area portion of 9.074×10⁵ µm² on the surface of the substrate. Therefore, the reflectivity of light having a wavelength of from 350 nm to 1,000 nm is 90% or above, the bending strength is 310 MPa or more, and the adhesion strength of the conductor 33 is 19 MPa or more. As a result, the comprehensive evaluation was "Acceptable".

Further, Sample Nos. 4 to 6, 9, 10. 12, 13, 17-24, 26, 27, 29, 30, 32 and 33 showed particularly good results that the number of pores having an equivalent circle diameter of 0.8 µm or more in the surface area portion of 9.074×10⁵ µm² on the surface 1a is from 9,000 to 11,000, and the reflectivity at a wavelength of 500 nm generally used in the evaluation of reflectivity is all 91% or above. From this fact, it is seen that more preferred range of the number of pores having an equivalent circle diameter of 0.8 µm or more is from 9,000 to 11,000.

Further, it is essential in the embodiment to contain at least one of calcium oxide and magnesium oxide. It is seen that silicon oxide is the essential component to satisfy all of sinterability, adhesion strength of a conductor by thick film printing and reflectivity, and particularly preferred range of silicon oxide is from 1% to 3 mass%.

### Example 2

Next, the relationship to the reflectivity by that the number of pores at the central part side of the ceramic substrate 1 for mounting a luminescent element is larger than that at the surface side thereof was examined.

Using the same raw materials as Sample No. 12 prepared in Example 1, a compact was prepared in the same step as in Example 1, and the compact was fired under the conditions of the respective firing temperature and firing time shown in Table 3 to prepare a substrate 1.

The measurement method of porosity is the same as in Example 1. However, when measuring the number of pores at the central part side, because the thickness of the substrate 1 is 0.635 mm, the substrate 1 was polished about 0.32 mm from the surface 1a, and the polished surface was measured in the same method as in Example 1. The reflectivity was measured in only the wavelength of 500 nm.

The results obtained are shown in Table 3.

**Table 3**

| Sample No, | Firing temperature | Firing time | Surface side | Central part side | Number obtained by subtracting the number of pores at central part side from the number of pores at surface side | Porosity |
|---|---|---|---|---|---|---|
| | | | Number of pores | Number of pores | | Wavelength 500 nm |
| | (°C) | (hour) | (Number) | (Number) | (Number) | (%) |
| 12-1 | 1530 | 7.5 | 10490 | 13125 | 2635 | 93.8 |
| 12-2 | 1520 | 8.0 | 10505 | 13020 | 2515 | 93.6 |
| 12 | 1500 | 9.0 | 10500 | 12810 | 2310 | 93.2 |
| 12-3 | 1480 | 10.0 | 10495 | 12600 | 2105 | 92.6 |
| 12-4 | 1470 | 10.5 | 10485 | 12390 | 1905 | 91.6 |

As is seen from the results in Table 3, the reflectivity is increased with increasing the number of pores at the central part side than the surface side. Therefore, it is seen that the substrates can well be used as a ceramic substrate for mounting a luminescent element.

### Example 3

Regarding Sample Nos. 1 and 14 which are Comparative Examples, and Sample Nos. 5, 12 and 13 which are Examples of the embodiment, prepared in Example 1, the average pore size and the reflectivity at a wavelength of from 200 nm to 350 nm were measured in the same measurement method as in Example 1.

The results obtained are shown in Table 4.

**Table 4**

| Sample No. | Average pore size | Reflectivity | | | |
|---|---|---|---|---|---|
| | | Wavelength 200 nm | Wavelength 250 nm | Wavelength 300 nm | Wavelength 350 nm |
| | (µm) | (%) | (%) | (%) | (%) |
| 1 | 2.02 | 17.7 | 23.0 | 68.9 | 78.9 |
| 5 | 1.95 | 20.4 | 60.0 | 80.8 | 91.0 |
| 12 | 1.52 | 25.6 | 65.7 | 85.7 | 91.7 |
| 13 | 1.00 | 23.2 | 64.5 | 85.5 | 91.0 |
| 14 | 0.95 | 19.8 | 52.5 | 82.4 | 91.0 |

As is seen from the results of Table 4, Sample No. 1 of Comparative Example in which the average pore size is large as 2.02 µm is that the reflectivity at a wavelength of 350 nm or less becomes rapidly low. Furthermore, the reflectivity in the case that the average pore size is small as 0.95 µm is that the reflectivity at a wavelength of 250 nm or less becomes low.

Sample Nos. 5, 12 and 13 which are Examples of the embodiment are that the average pore size is a range of from 1.00 µm to 1.95 µm, the reflectivity is 80% or above up to the wavelength of 300 nm and is 60% or above up to the wavelength of 250 nm, and the reflectivity in ultraviolet region, becoming the problem can markedly be improved.

The action of the average pore size in the results is not clarified, but it is seen that when the average pore size is a range of from 1 µm to 1.95 µm, the average pore size contributes to the improvement of reflectivity in near-ultraviolet region.

As described above, the ceramic substrate 1 for mounting a luminescent element of the embodiment is that barium having high material cost is not used, sinterability is increased even at a temperature of from 1,420°C to 1,540°C, which is lower than the ordinary temperature, and as a result, low cost of the substrate 1 can be achieved. Furthermore, the ceramic substrate 1 of the embodiment is a ceramic substrate suitable for mounting a luminescent element, in which bending strength is high, sufficient adhesion strength of a conductor is maintained even though an electrode is directly thick film-printed on the substrate 1, high reflectivity is obtained at a wavelength of a broad range over from the entire visible light region to a part of ultraviolet region and infrared region, and both high reflectivity and mechanical characteristics can sufficiently be satisfied.

### Reference Signs List

1: Ceramic substrate for mounting luminescent element (Substrate)
   1a, 1a': Surface
2: Luminescent element
3, 33: Conductor
   3a, 3b: Electrode pad
   3c, 3d: Front electrode
   3e, 3f: Through conductive layer
   3g, 3h: Back electrode
4: Alumina particle
5: Glass phase (grain boundary phase)
6: Pore
7: Interface (Interface between alumina particle and glass phase)
8: Interface (Interface between pore and glass phase)
11: Incident light
12: Transmitted light
13: Reflected light
   13a: Regularly reflected light
   13b: Diffusely-reflected light
   13c: Diffusely-reflected light
   13d: Diffusely-reflected light
21: Luminescent device
31: Resin
32: Lens
34: Solder
35: Plated conductive wire

## Claims

1. A ceramic substrate for mounting a luminescent element, comprising:
a content of aluminum oxide of from 94 mass% to 97 mass%;
silicon oxide; and
at least one of calcium oxide and magnesium oxide,
wherein the ceramic substrate has a porosity of from 2.5% to 4.5%, a number of pores of from 7,000 to 11,000, and a cumulative relative frequency of 70% or above in an equivalent circle diameter of 1.6 µm or less in a pore distribution, when viewing pores having an equivalent circle diameter of 0.8 µm or more in a surface area portion of 9.074×10⁵ µm² of a surface of the substrate.

2. The ceramic substrate for mounting a luminescent element according to claim 1,
wherein when reviewing the pores having an equivalent circle diameter of 0.8 µm or more, a number of pores at a central part side of the substrate is larger than that at the surface side thereof.

3. The ceramic substrate for mounting a luminescent element according to claim 1 or 2,
wherein a content of the silicon oxide is from 1 mass% to 3 mass%.

4. The ceramic substrate for mounting a luminescent element according to any one of claims 1 to 3,
wherein an average pore size of pores in the surface is from 1.0 µm to 1.95 µm.

5. A luminescent device, comprising:
the ceramic substrate for mounting a luminescent element according to any one of claims 1 to 4; and
a luminescent element placed on the substrate.
